# EUROPEAN PATENT SPECIFICATION

(11) **EP 2 023 701 B1**
(45) Date of publication and mention of the grant of the patent: **08.12.2010**
(21) Application number: 07743047.8
(22) Date of filing: 09.05.2007
(51) Int. Cl.: H05K 3/46, H05K 3/00

(54) **METHOD FOR MANUFACTURING CERAMIC MULTILAYER SUBSTRATE**
VERFAHREN ZUR HERSTELLUNG EINES KERAMISCHEN, MEHRSCHICHTSUBSTRATS
PROCÉDÉ DE FABRICATION DE SUBSTRAT MULTICOUCHE CERAMIQUE

(30) Priority: 29.05.2006 JP 2006148246
(43) Date of publication of application: 11.02.2009
(73) Proprietor: Murata Manufacturing Co. Ltd., Nagaokakyo-shi, Kyoto 617-8555 (JP)
(72) Inventor: KAWAMURA, Akiyoshi, Nagaokakyo-shi, Kyoto 617-8555 (JP); TSUKIZAWA, Takayuki, Nagaokakyo-shi, Kyoto 617-8555 (JP); IKEDA, Tetsuya, Nagaokakyo-shi, Kyoto 617-8555 (JP)
(74) Representative: Schoppe, Fritz
(86) International application number: PCT/JP2007/059612
(87) International publication number: WO 2007/138826

(56) References cited:
- JP-A- 2001 332 857
- JP-A- 2002 016 359
- JP-A- 2002 270 459

## Description

### Technical Field

The present invention relates to a method for producing a multilayer ceramic substrate. In particular, the present invention relates to a method for producing a multilayer ceramic substrate including a plurality of stacked ceramic layers.

### Background Art

Multilayer ceramic substrates including a plurality of stacked ceramic layers can be efficiently produced by simultaneously firing a source substrate including a plurality of multilayer ceramic substrates and cutting the source substrate into individual multilayer ceramic substrates after firing.

For example, Patent Document 1 discloses that ceramic green sheets having dividing lines are transferred and laminated to form a laminate, dividing grooves are formed by, for example, irradiating the dividing lines with a CO₂ laser after the laminate is subjected to heat treatment, and the laminate is separated into many substrates.

Patent Document 2 discloses that dividing grooves are formed in advance in either or both of front and back surfaces of press-bonded ceramic green sheets, and the resulting substrate is bent to form cracks from the dividing grooves after heat treatment, thereby separating the substrate into many substrates.
Patent Document 1: Japanese Unexamined Utility Model Registration Application Publication No. 4-38071
Patent Document 2: Japanese Unexamined Patent Application Publication No. 5-75262

In Patent Document 1, however, an expensive, large-scale CO2 laser irradiation apparatus is required. The laser irradiation requires a long time. During cutting, the substrates may be broken by thermal strain, and deformation and/or alteration due to the heat of the laser may occur at and around sections of the substrate.

In the method disclosed in Patent Document 2, in the press-bonded sheets after the formation of the dividing grooves, failures, such as deformation and breakage, may occur due to the dividing grooves during conveyance. When the heat-treated substrate is bent, the substrate may be broken at undesirable positions other than the grooves, resulting in defective articles. Although the substrate is separated along the dividing grooves, sections may have irregular shapes, resulting in out-of-specification products.

JP 2002-270459 A describes a manufacturing method for a laminated ceramic electronic component shortening the time needed to divide a laminated green sheet into individual chips after thermocompression bonding. Parting lines are formed an green sheets before thermocompression bonding. The parting lines are formed by printing a paste on the green sheets. During the thermocompression bonding at least a part of the parting lines is removed and a line cavity is formed in the part where the parting lines existed. After the green sheets are stacked and bonded by thermocompression, the laminated green sheet is divided along the parting lines in the laminating direction.

### Summary of the Invention

It is an object of the present invention provide a method for accurately and easily producing a multilayer ceramic substrate overcoming the problems described above.

This object is achieved by a method according to claim 1.

A method for producing a multilayer ceramic substrate includes (1) a first step of forming a green ceramic laminate including a plurality of stacked green ceramic layers, (2) a second step of firing the green ceramic laminate to sinter the green ceramic layers, and (3) a third step of dividing the sintered ceramic laminate formed by firing the green ceramic laminate into a plurality of pieces. The green ceramic laminate formed in the first step includes at least one green boundary-defining thick-film pattern arranged on one main surface of at least one of the green ceramic layers and along a portion corresponding to the boundary between the pieces of the sintered ceramic laminate divided in the third step, the at least one green boundary-defining thick-film pattern having firing behavior different from that of the green ceramic layers adjacent to the at least one green boundary-defining thick-film pattern. In the second step, a cavity is formed on the basis of the difference in firing shrinkage behavior between the at least one boundary-defining thick-film pattern and the ceramic layers in contact with the at least one boundary-defining thick-film pattern, the cavity being adjacent to at least part of an outer edge of the at least one boundary-defining thick-film pattern when viewed in the stacking direction of the ceramic layers. In the third step, the sintered ceramic laminate is divided along the cavity into the plurality of pieces.

According to the above-described method, in the sintered ceramic laminate, the cavity is formed at a side of the sintered boundary-defining thick-film pattern on the basis of the difference in firing shrinkage behavior, such as a firing shrinkage initiation temperature, a firing shrinkage termination temperature, and a firing shrinkage, between the ceramic layer and boundary-defining thick-film pattern, rate. The sintered ceramic laminate can be divided into the pieces separated through the cavity. Each of the pieces formed by dividing the sintered ceramic laminate may be an individual piece divided in response to a final product. Alternatively, each of the pieces may be an intermediate product including a plurality of subpieces to be further divided in the downstream process. The green ceramic layers may be ceramic green sheets formed by forming a ceramic powder into sheets. Alternatively, the green ceramic layers may be thick-film printed layers formed by forming a paste including a ceramic powder into layers by printing.

According to a preferred embodiment, the firing shrinkage initiation temperature of the at least one green boundary-defining thick-film pattern is lower than those of the green ceramic layers in contact with the boundary-defining thick-film pattern.

In this case, in the second step, as the firing temperature increases, the boundary-defining thick-film pattern begins to shrink earlier than the ceramic layers around the pattern. Thus, the cavity is formed at a side of the boundary-defining thick-film pattern.

According to another preferred embodiment, the firing shrinkage rate of the at least one green boundary-defining thick-film pattern is higher than those of the ceramic layers in contact with the at least one boundary-defining thick-film pattern.

In this case, the firing shrinkage rate of the boundary-defining thick-film pattern is higher than those of the ceramic layers around the pattern during firing in the second step. Thus, the cavity is formed at a side of the boundary-defining thick-film pattern.

Preferably, the at least one boundary-defining thick-film pattern comprises a plurality of boundary-defining thick-film patterns, wherein the boundary-defining thick-film patterns are arranged at different interfaces among the green ceramic layers, and at least part of an outer edge of each of the boundary-defining thick-film patterns is arranged in a common imaginary plane extending in the stacking direction of the green ceramic layers.

In this case, the common imaginary plane of a plurality of cavities extending in the stacking direction is defined as a boundary, and the sintered ceramic laminate can be divided at the boundary. The plurality of the boundary-defining thick-film patterns may be arranged on either or both sides of the common imaginary plane.

Preferably, the first step includes a substep of bringing a green shrinkage inhibiting layer that is not substantially sintered at a firing temperature of the green ceramic layers into close contact with at least one main surface of the green ceramic laminate. In the second step, the green ceramic laminate in close contact with the shrinkage inhibiting layer is fired at a temperature from a sintering temperature of the ceramic layers to a temperature at which the shrinkage inhibiting layer is not substantially sintered. The method further includes a step of removing the shrinkage inhibiting layer in close contact with the sintered ceramic laminate between the second step and the third step.

In this case, the firing shrinkage of the green ceramic laminate is inhibited by the shrinkage inhibiting layer in the direction perpendicular to the stacking direction (i.e., a main surface direction). The green ceramic laminate shrinks significantly in the thickness direction, thereby easily forming the cavity at a side of the boundary-defining thick-film pattern.

Preferably, the at least one green boundary-defining thick-film pattern is a green boundary-defining conductive pattern containing a conductive material.

Preferably, the sintered ceramic laminate includes an internal circuit conductive pattern constituting an embedded element arranged between the ceramic layers. Preferably, the internal circuit conductive pattern is electrically remote from the boundary-defining conductive pattern.

In this case, the internal circuit conductive pattern constitutes the embedded element, such as a capacitor, an inductor, a lead, or a ground, after firing. The internal circuit conductive pattern and the boundary-defining conductive pattern are electrically independent of each other. Thus, different materials may be used therefor. That is, the boundary-defining conductive pattern may be composed of a material that forms the cavity adjacent to an outer edge of the boundary-defining conductive pattern. The internal circuit conductive pattern may be composed of a material that does not form the cavity adjacent to an outer edge of the internal circuit conductive pattern (embedded element). Flexibility in the choice of a material is high.

Preferably, at least part of the boundary-defining conductive pattern constitutes an embedded element arranged between the ceramic layers of the sintered ceramic laminate.

In this case, the boundary-defining conductive pattern can also serve as at least part of the internal circuit conductive pattern constituting the embedded element. The boundary-defining conductive pattern and the internal circuit conductive pattern can be composed of the same material, thus simplifying the process. Furthermore, the boundary-defining conductive pattern and the internal circuit conductive pattern can be arranged with no space therebetween, thus resulting in a reduction in the size of the multilayer ceramic substrate. Moreover, the embedded element can be electrically connected to the outside with the boundary-defining conductive pattern exposed at sections of the sintered ceramic laminate.

Preferably, the method further includes a step of mounting a surface-mounted electronic component on the sintered ceramic laminate before or after the sintered ceramic laminate is divided into the plurality of pieces.

According to the present invention, the sintered laminate is divided by utilizing the cavity formed on the basis of the difference in firing shrinkage behavior between the green ceramic layers and the green boundary-defining thick-film pattern. Thus, the multilayer ceramic substrate can be produced accurately and easily.

That is, sections of the sintered ceramic laminate pass through the cavity, thereby practically eliminating misalignment and variations in shape. This also results in the elimination of separation at an undesirable position, breakage during cutting, or variations in section.

Furthermore, a thick-film pattern may be simply formed at a desirable position of the green ceramic laminate as well as a conductive pattern. The cavity is formed by firing. Thus, deformation and breakage are not caused from the cavity during the conveyance of the green multilayer ceramic substrate. The sintered ceramic laminate can be easily cut by applying a stress to the cavity. For example, an expensive, large-scale CO₂ laser irradiation apparatus is not particularly required. The application of heat is not required during cutting, thereby inhibiting the deformation and alteration due to heat at and around the sections.

### Brief Description of the Drawings

Figs. 1(a) to 1(c) are cross-sectional views illustrating a production process of multilayer ceramic substrates (first embodiment).
Fig. 2 is a plan view of a boundary-defining conductive pattern (first embodiment).
Fig. 3 is a perspective view of a section of a multilayer ceramic substrate (first embodiment).
Fig. 4 is a graph showing shrinkage rates (first embodiment).
Fig. 5 is a cross-sectional view of a multilayer ceramic substrate (first alternative embodiment).
Fig. 6 is a plan view of a boundary-defining conductive pattern (second alternative embodiment).
Figs. 7(a) to 7(d) are cross-sectional views illustrating a production process of multilayer ceramic substrates (second embodiment).

### Reference Numerals

10 multilayer ceramic substrate
11 section
11a ceramic-layer-break portion
11b cavity-separation portion
12a green ceramic laminate
12b sintered ceramic laminate
14 in-plane conductive pattern (conductive pattern)
15 conductive via pattern (conductive pattern)
16, 16a, 16b boundary-defining conductive pattern (conductive pattern)
18a, 18b cavity
20, 22 shrinkage inhibiting green sheet
50 green ceramic laminate
52 sintered ceramic laminate
52a, 52b piece
54 in-plane conductive pattern (boundary-defining conductive pattern)
56 cavity
58a, 58b section

### Best Mode for Carrying Out the Invention

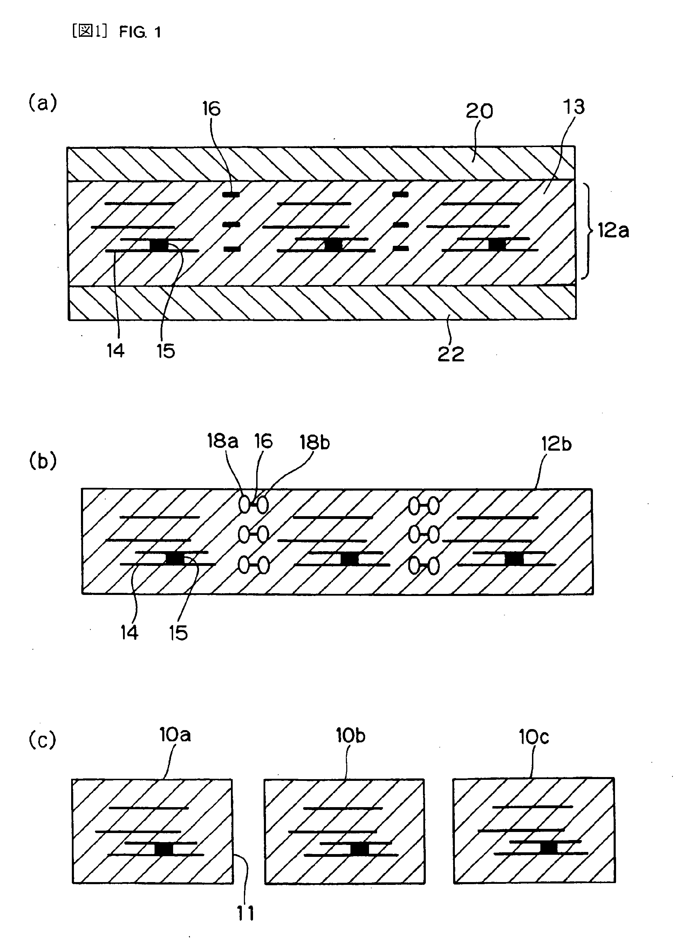

Embodiments of the present invention will be described below with reference to Figs. 1 to 7.

### <First Embodiment>

A method for producing a multilayer ceramic substrate according to a first embodiment will be described below with reference to Figs. 1 to 4.

A brief outline of the method for producing a multilayer ceramic substrate will be described below with reference to Fig. 1 which is a cross-sectional view.

As shown in Fig. 1(a), shrinkage inhibiting green sheets 20 and 22 in close contact with both surfaces of a green ceramic laminate 12a including portions to be formed into a plurality of multilayer ceramic substrates are fired.

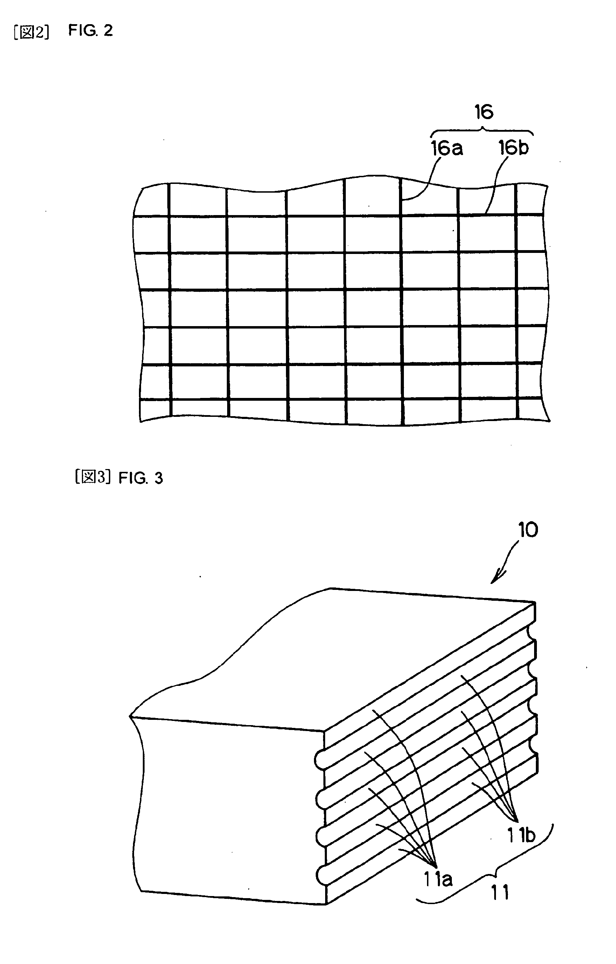

The green ceramic laminate 12a includes in-plane conductive patterns 14 to be formed into internal electrodes, internal leads, embedded elements, and the like in the multilayer ceramic substrates, the in-plane conductive patterns 14 being arranged between a plurality of stacked ceramic green sheets 13; and boundary-defining conductive patterns 16 arranged along boundaries among the multilayer ceramic substrates. As shown in Fig. 2 which is a plan view viewed in the stacking direction of the ceramic green sheets 13, the boundary-defining conductive patterns 16 each include segments 16a extending longitudinally and segments 16b extending laterally, the segments 16a and 16b being arranged along boundaries of the portions to be formed into the multilayer ceramic substrates arrayed in a matrix.

Conductive via patterns 15 passing through the ceramic green sheets 13 and connected to the in-plane conductive patterns 14 are formed in the ceramic green sheets 13.

The shrinkage behavior of the ceramic green sheets 13 and the shrinkage behavior of the in-plane conductive patterns 14 are adjusted in such a manner that a cavity is not formed between the ceramic layers during firing. The boundary-defining conductive patterns 16 is composed of a material such that the sintering behavior thereof when the green ceramic laminate 12a is fired is significantly different from the sintering behavior of the ceramic green sheets 13. The boundary-defining thick-film patterns are preferably conductive patterns mainly composed of a conductive material such as Ag or Cu. Alternatively, the boundary-defining thick-film patterns may be an insulating patterns mainly composed of an insulating material such as a ceramic material or glass.

As schematically shown in Fig. 1(b), cavities 18a and 18b are formed at sides of each boundary-defining conductive pattern 16 in a fired ceramic laminate 12b. That is, the ceramic layers that sandwich the boundary-defining conductive patterns 16 shrink in the vicinity of the outer edges of the boundary-defining conductive patterns 16 due to the contact with the boundary-defining conductive patterns 16. Thereby, the cavities 18a and 18b are formed between the ceramic layers. Fig. 1(b) shows a state after the removal of the shrinkage inhibiting layers.

For example, the boundary-defining conductive patterns 16 are formed of a Ag paste having a shrinkage rate higher than those of the ceramic green sheets 13 during sintering by heat. In this case, the amount of shrinkage of each boundary-defining conductive pattern 16 is larger than that of the ceramic green sheets arranged around the pattern 16. Thus, the cavities 18a and 18b are formed at the sides of each boundary-defining conductive pattern 16.

Alternatively, the boundary-defining conductive patterns 16 are formed of a Ag paste having a sintering initiation temperature lower than that of each ceramic green sheet 13. In this case, the boundary-defining conductive patterns 16 begin to shrink earlier than the ceramic green sheets around the patterns 16. Thus, the cavities 18a and 18b are formed at the sides of each boundary-defining conductive pattern 16.

The fired ceramic laminate 12b can be divided by bending into pieces 10a, 10b, and 10c, to be formed into the multilayer ceramic substrates, separated through the cavities 18a and 18b as schematically shown in Fig. 1(c).

As shown in Fig. 3, cavity-separation portions 11b formed by dividing the cavities 18a and 18b and having a depressed shape and substantially flat ceramic-layer-break portions 11a formed by breakage of the ceramic layers are exposed at section 11 of each of the pieces 10a, 10b, and 10c. For ceramic grains constituting the ceramic layers, only grain boundary failure occurs at the cavity-separation portions 11b. Grain boundary failure and intragranular failure occur at the electric signal 11a.

To promote the initiation of separation, one or more grooves may be formed in either or both main surfaces of the green ceramic laminate 12a.

An example of the production of the multilayer ceramic substrates will be described below.

Ceramic green sheets containing ceramic materials are prepared.

Specifically, the ceramic green sheets are produced as follows: A mixture of 50 to 65 percent by weight of a glass powder having a composition of CaO (10% to 55%), SiO₂ (45% to 70%), Al₂O₃ (0% to 30% by weight), impurities (0% to 10% by weight), and B₂O₃ (0% to 20% by weight) and 35 to 50 percent by weight of an Al₂O₃ powder containing 0% to 10% by weight impurities is dispersed in an organic vehicle including an organic solvent, a plasticizer, and the like to prepare a slurry. The resulting slurry is formed into sheets by a doctor blade method or casting. Thereby, green glass ceramic layers (ceramic green sheets) are produced.

The green glass ceramic layers (ceramic green sheets) are preferably ceramic green sheets formed by the above-described sheet-forming method. Alternatively, the green glass ceramic layers may be green thick printed layers. With respect to the ceramic powder, a magnetic material, such as ferrite, and a dielectric material, such as barium titanate, may be used as well as the above-described insulating material. As the ceramic green sheets, low-temperature co-fired ceramic green sheets that are sintered at 1,050°C or lower are preferred. Thus, the above-described glass powder has a softening point of 750°C or lower.

Vias are formed in the green glass ceramic layers by punching or the like. Examples of a method for forming the in-plane conductive patterns 14 include a method in which a conductive paste is applied by screen printing, gravure printing, or the like, and a method in which metal foil having a predetermined shape is transferred.

As the conductive material, a material mainly composed of Ag having low resistivity and oxidation resistance is preferred. In particular, when a higher bond strength to a ceramic material is required, at least one additive, such as Al₂O₃, may be incorporated in addition to Ag as a main component.

The conductive paste may be produced by adding a predetermined proportion of an organic vehicle to the above-described the main component powder, and stirring and kneading the mixture. However, the sequence of mixing the main component powder, the additive powder, the organic vehicle, and the like is not particularly limited.

The organic vehicle is a mixture of a binder resin and a solvent. Examples of the binder resin that can be used include ethyl cellulose, acrylic resins, polyvinyl butyral, and methacrylic resins.

Examples of the solvent that can be used include terpineol, dihydroterpineol, dihydroterpineol acetate, butyl carbitol, butyl carbitol acetate, and alcohols.

As needed, various dispersants, plasticizers, activators may be incorporated.

The conductive paste preferably has a viscosity of 50 to 700 Pa·s in view of printability.

The conductive patterns arranged on the surface includes portions where the conductive via patterns 15, such as via-hole conductors and through-hole conductors, for connection of conductive patterns arranged different interfaces among the layers are exposed at the surface. The conductive via patterns 15 are formed by filling the above-described paste into the through holes, which are formed in the glass ceramic green sheets by punching or the like, by printing or the like.

A paste for forming the boundary-defining conductive patterns 16 is formed and applied by printing as well as the paste for forming the in-plane conductive patterns 14. Preferably, with respect to a Ag powder mainly constituting the paste, coarse particles and extremely aggregated particles are not contained therein. The conductive paste preferably has a maximum particle size of 5 µm or less.

The shrinkage inhibiting green sheets are produced as follows: A powder of a ceramic material, such as alumina, which is not substantially sintered at a firing temperature of the above-described green glass ceramic layers (ceramic green sheets) is dispersed in an organic vehicle containing an organic binder, an organic solvent, a plasticizer, and the like to prepare a slurry. The resulting slurry is formed into sheets by a doctor blade method or casting. Thereby, the shrinkage inhibiting green sheets are produced. The shrinkage inhibiting green sheets are sintered at, for example, 1,400°C to 1,600°C and thus are not substantially sintered at the firing temperature of the green glass ceramic layers (ceramic green sheets).

Each of the shrinkage inhibiting green sheets may have a single-layer structure or a structure including a plurality of stacked layers. The ceramic powder used for the shrinkage inhibiting green sheets preferably has an average particle size of 0.1 to 5.0 µm. In the case of the ceramic powder having an average particle size of less than 0.1 µm, the powder reacts vigorously with the glass components contained in the vicinity of surfaces of the green glass ceramic layers; hence, in some cases, the glass ceramic layers are bonded to the shrinkage inhibiting green sheets after firing. As a result, the shrinkage inhibiting green sheets cannot be removed. Furthermore, delamination may occur in the substrate because the organic components, such as the binder, in the sheets are not easily eliminated due to such a small particle size. On the other hand, the ceramic powder having an average particle size exceeding 5.0 µm tends to have a reduced inhibiting power to inhibit firing shrinkage, thereby causing the substrate to shrink unnecessarily in the x and y directions or to warp.

The ceramic powder constituting the shrinkage inhibiting green sheets may be a ceramic powder that is not substantially sintered at the firing temperature of the green glass ceramic layers. Ceramic powders such as zirconia and magnesia may be used as well as alumina. However, to increase the amount of the glass components in surface regions of the green glass ceramic layers, the glass components in the surfaces need to have good wettability for the shrinkage inhibiting green sheets at interfaces where the surfaces are in contact with the shrinkage inhibiting green sheets. Thus, the same ceramic powder as the ceramic powder constituting the green glass ceramic layers is preferred.

The ceramic green sheets including the in-plane conductive patterns, the conductive via patterns, and the boundary-defining conductive patterns are stacked to form a green ceramic laminate. A composite laminate including the shrinkage inhibiting green sheets arranged on both main surfaces of the ceramic laminate is produced by superposing the shrinkage inhibiting green sheets on one main surface and the other main surface of the green ceramic laminate and press-bonding the resulting article by isostatic pressing at a pressure of, for example, 5 to 200 MPa.

Preferably, each of the shrinkage inhibiting green sheets has a thickness of 25 to 500 µm. The shrinkage inhibiting green sheets each having a thickness of less than 25 µm have a reduced inhibiting power to inhibit firing shrinkage, thereby allowing the substrate to shrink unnecessarily in the x and y directions or to warp, in some cases. At a thickness exceeding 500 µm, delamination tends to occur in the substrate because the organic components, such as the binder, in the sheets are not easily eliminated.

The composite laminate is fired with a known belt furnace or a batch furnace at a firing temperature, e.g., 850°C to 950°C, of the ceramic green sheets of the ceramic laminate to sinter the ceramic laminate. In this case, the green ceramic laminate shrinks significantly in the thickness direction but does not substantially shrink in the planar direction owing to the restraint effect of the shrinkage inhibiting green sheets.

The shrinkage inhibiting green sheets are removed from the composite laminate after firing to obtain the sintered ceramic laminate including portions to be formed into the plurality of multilayer ceramic substrates.

In the sintered composite laminate, the shrinkage inhibiting green sheets are not substantially sintered. The organic components contained therein before firing are eliminated. As a result, the shrinkage inhibiting green sheets become porous. Thus, the shrinkage inhibiting green sheets can be easily removed by sand blasting, wet blasting, a supersonic vibration technique, or the like.

The ceramic laminate obtained by removing the shrinkage inhibiting green sheets is divided along the boundaries of the multilayer ceramic substrates into the pieces of the multilayer ceramic substrates.

When the ceramic laminate is divided after firing, the stress concentration occurs in the vicinity of the cavities formed along the boundaries among the multilayer ceramic substrates to form cracks, resulting in the multilayer ceramic substrates each having target dimensions and smooth sections. The sections may be further smoothed by a smoothing process, such as barrel polishing.

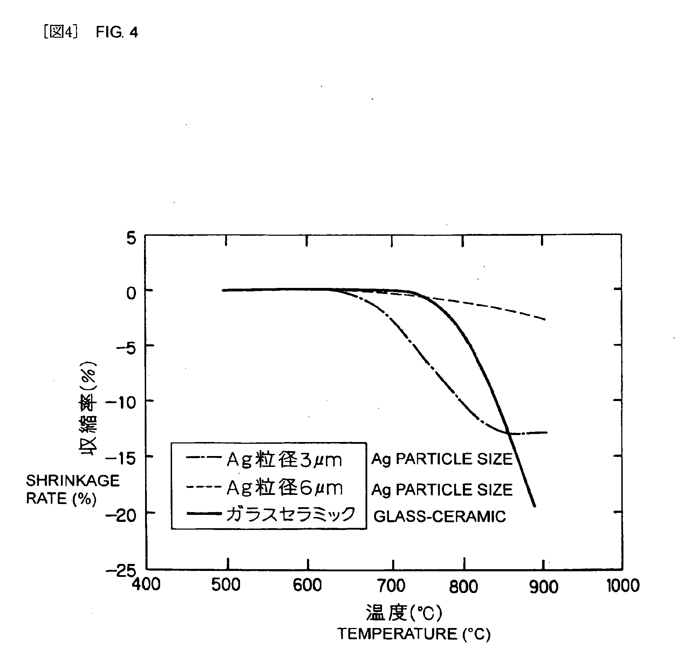

Fig. 4 is a graph showing the TMA measurement results of the Ag pastes used for forming the boundary-defining conductive patterns and a glass-ceramic base material used for the ceramic green sheets. The graph clearly demonstrates great differences in shrinkage timing and the shrinkage rates.

The shrinkage curve, indicated by a solid line, of the glass-ceramic base material lies at an intermediate position between the Ag pastes having Ag particle sizes of 3 µm and 6 µm. The Ag paste having a particle size of 3 µm, indicated by a two-dot chain line, has a shrinkage initiation temperature lower than that of the glass-ceramic base material indicated by the solid line and a shrinkage rate higher than that of the Ag paste having a particle size of 6 µm.

In the case where the Ag paste having a particle size of 3 µm is used for forming the boundary-defining conductive patterns, cavities are formed in the vicinity of interfaces among the boundary-defining conductive patterns and the ceramic layers after firing. On the other hand, in the case where the Ag paste having a particle size of 6 µm is used for forming the boundary-defining conductive patterns, cavities are not formed in the vicinity of interfaces among the boundary-defining conductive patterns and the ceramic layers after firing. Accordingly, the results demonstrate that the Ag paste used for forming the boundary-defining conductive patterns preferably has a particle size of 4 to 5 µm.

The shrinkage behavior of the Ag paste varies not only depending on the Ag particle size but also, for example, the Ag content of the paste and the impurity content other than Ag. Specifically, the paste may have a Ag content of 85 percent by weight or less. The paste may contain 0.5 percent by weight or more of Al₂O₃ as an impurity.

The presence and size of the cavities formed at the sides of each boundary-defining conductive pattern can be controlled by utilizing differences between the boundary-defining thick-film patterns and the ceramic green sheets in the shrinkage initiation temperature, the shrinkage termination temperature, and the shrinkage rate. For example, the presence and size of the cavities formed at the sides of each boundary-defining conductive pattern can be controlled by appropriately selecting the Ag particle size, particle-size distribution, shape (sphere, flat, etc.), and specific surface area in the Ag paste used for forming the boundary-defining conductive patterns. The presence and size of the cavities formed at the sides of each boundary-defining conductive pattern can also be controlled by appropriately selecting the particle size, particle-size distribution, shape, specific surface area, and material, of an additive, the presence of coating (surface state of Ag), a binder, a solvent, and the like.

### <First Alternative Embodiment>

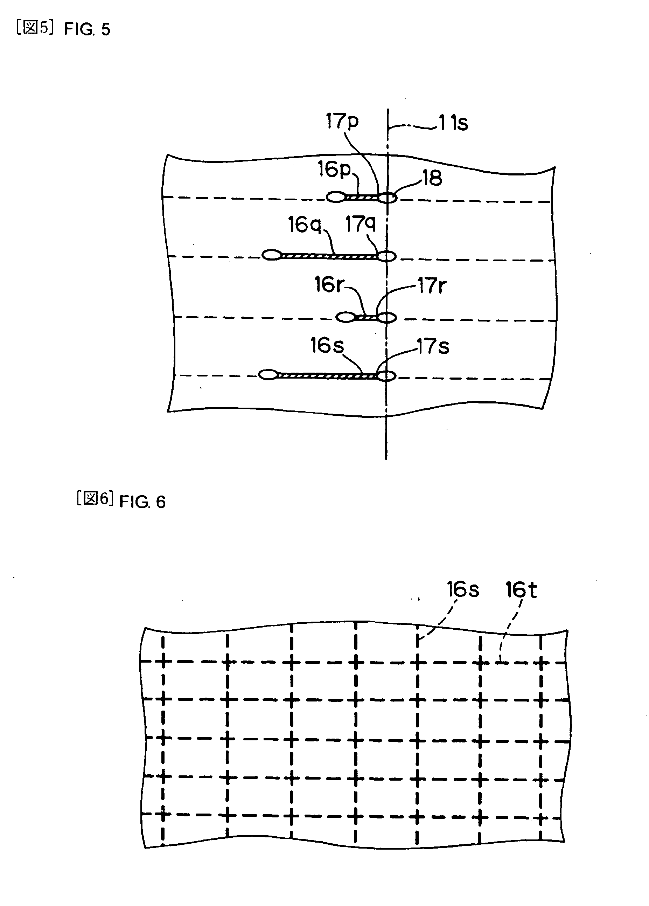

The ceramic laminate is separated at a section through one of the cavities formed at both sides of each boundary-defining conductive pattern. To form the section more accurately, as shown in Fig. 5 which is a cross-sectional view, the positions and widths of the boundary-defining conductive patterns 16p, 16q, 16r, and 16s may be changed in such a manner that sides 17p, 17q, 17r, and 17s of individual boundary-defining conductive patterns 16p, 16q, 16r, and 16s are aligned along the boundaries of the multilayer ceramic substrates. Thereby, the ceramic laminate after firing can be separated at section 11s passing through the cavities 18 formed at the sides 17p, 17q, 17r, and 17s aligned in the stacking direction of the boundary-defining conductive patterns 16p, 16q, 16r, and 16s.

The boundary-defining conductive patterns may also be arranged both sides of the section. Alternatively, the boundary-defining conductive patterns may overlap the in-plane conductive patterns.

### <Second Alternative Embodiment>

As shown in Fig. 6, boundary-defining conductive pattern segments 16s and 16t may be discontinuously formed.

### <Third Alternative Embodiment>

The boundary-defining conductive patterns may be formed part of the boundaries in place of the formation of boundary-defining conductive pattern segments 16a and 16b; or 16s and 16t in a lattice shape as shown in Figs. 2 and 6. For example, the boundary-defining conductive patterns may be formed longitudinally or laterally. In this case, the source substrate can be separated into strips.

### <Second Embodiment>

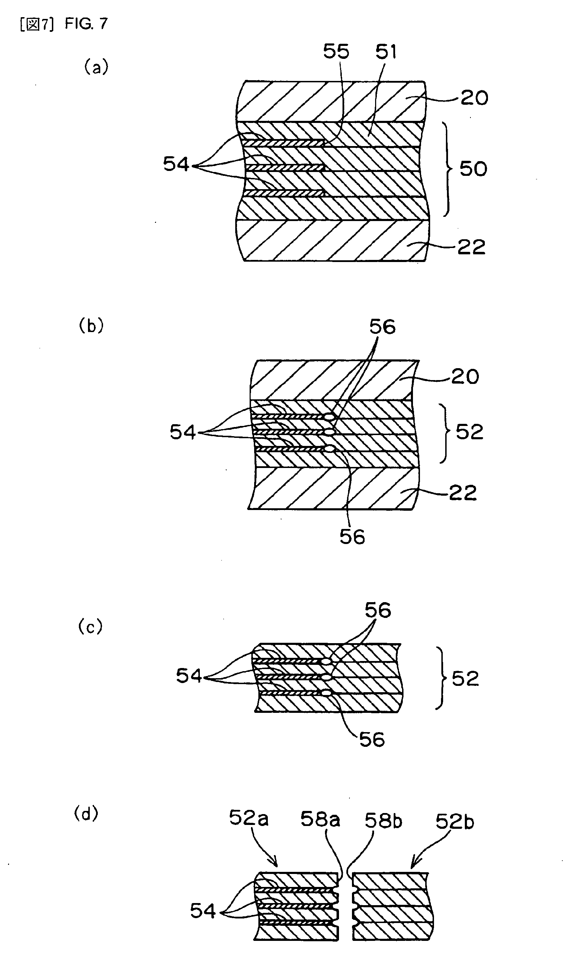

As shown in Fig. 7 which is a cross-sectional view, the boundary-defining conductive patterns may be formed so as to function also as the in-plane conductive patterns constituting the internal electrodes, leads, embedded elements, and the like.

In this case, as shown in Fig. 7(a), a green ceramic laminate 50 is formed in such a manner that individual sides 55 of in-plane conductive patterns 54 (e.g., internal electrodes of a capacitor) arranged between ceramic green sheets 51 are aligned along boundaries of multilayer ceramic substrates. The in-plane conductive patterns 54 are composed of a material having firing shrinkage behavior different from that of the ceramic green sheets 51, as in the first embodiment. The shrinkage inhibiting green sheets 20 and 22 are in close contact with both surfaces of the green ceramic laminate 50, as in the first embodiment.

Firing is performed at a temperature at which the ceramic green sheets 51 are sintered but the shrinkage inhibiting green sheets 20 and 22 are not substantially sintered. Thereby, as shown in Fig. 7(b), cavities 56 are formed in the sintered ceramic laminate 52 and are adjacent to sides 55 of the in-plane conductive patterns 54 which are aligned.

As shown in Fig. 7(c), the shrinkage inhibiting green sheets 20 and 22 are removed to obtain the sintered ceramic laminate 52 (source substrate).

As shown in Fig. 7(d), the sintered ceramic laminate 52 (source substrate) is separated by bending into portions 52a and 52b having sections 58a and 58b passing through the cavities 56. External electrodes may be formed so as to be connected to end faces of the in-plane conductive patterns exposed at a side face. In the case where the external electrodes are not required, an insulating protective film may be formed.

### <Summary>

As described above, when the boundary-defining conductive patterns formed by printing on the ceramic green sheets have sintering shrinkage behavior different from that of the ceramic green sheets during firing, the cavities adjacent to individual edges of the boundary-defining conductive patterns in the ceramic laminate are formed after firing. It is possible to form the cavities in the multilayer ceramic substrate without the formation of a groove or cavity in the ceramic green sheets before firing and without additional processing of forming a separation groove in the ceramic laminate after firing. In the case where the boundary-defining conductive patterns are formed on the front or back surface of the multilayer ceramic substrate, grooves are formed on the front or back surface of the multilayer ceramic substrate and are adjacent to individual edges of the boundary-defining conductive patterns.

When the source substrate is bent, cracks passing through the cavities or grooves where the cross sectional thickness is reduced are formed, thus forming the sections passing through the cavities or grooves. Therefore, the source substrate can be divided accurately and easily into individual substrates. Hence, many circuit boards can be obtained from the single substrate.

The boundary-defining conductive patterns may be formed on the ceramic green sheets in a step of forming the conductive patterns such as the internal electrodes and lead patterns. Thus, this eliminates the need to form a groove or a cavity, in advance, in the ceramic green sheets before firing or the ceramic laminate before firing. After firing, the ceramic laminate can be separated by bending. Thus, this eliminates the need for the processing of the ceramic laminate with a special cutting apparatus for cutting the hard ceramic laminate after firing (e.g., a laser beam machine, a dicing saw, or the like), thereby simplifying the process.

Also in the case where the number of stacked ceramic layers is increased, sections can be accurately made by aligning the cavities in the stacking direction, thereby accurately and easily producing the multilayer ceramic substrate with high dimensional accuracy.

The present invention is not limited to the above-described embodiments. Various changes may be made.

## Claims

1. A method for producing a multilayer ceramic substrate, comprising:
a first step of forming a green ceramic laminate (12a) including a plurality of stacked green ceramic layers (13);
a second step of firing the green ceramic laminate (12a) to sinter the green ceramic layers (13); and
a third step of dividing the sintered ceramic laminate (12b) formed by firing the green ceramic laminate (12a) into a plurality of pieces (10a-10c);
wherein the green ceramic laminate (12a) formed in the first step includes at least one green boundary-defining thick-film pattern (16, 16a, 16b; 16t, 16s; 54) arranged on a main surface of at least one of the green ceramic layers (13) and along a portion corresponding to the boundary between the pieces (10a-10c) of the sintered ceramic laminate (12b) divided in the third step;
wherein the at least one green boundary-defining thick-film pattern (16, 16a, 16b; 16t, 16s; 54) has firing shrinkage characteristics that are different from those of the green ceramic layers (13) adjacent to the at least one green boundary-defining thick-film pattern (16, 16a, 16b; 16t, 16s; 54);
wherein in the second step, a cavity (18a, 18b; 56) is formed due to the differences in firing shrinkage characteristics between the at least one boundary-defining thick-film pattern (16, 16a, 16b; 16t, 16s; 54) and the ceramic layers (13) in contact with the at least one boundary-defining thick-film pattern (16, 16a, 16b; 16t, 16s; 54);
wherein the cavity (18a, 18b; 56) is adjacent to at least a portion of an outer edge of the at least one boundary-defining thick-film pattern (16, 16a, 16b; 16t, 16s; 54) when viewed in the stacking direction of the ceramic layers (13); and
wherein in the third step, the sintered ceramic laminate (10a-10c) is divided along the cavity (18a, 18b; 56) into the plurality of pieces (10a-10c).

2. The method for producing a multilayer ceramic substrate according to claim 1, wherein the firing shrinkage initiation temperature of the at least one green boundary-defining thick-film pattern (16, 16a, 16b; 16t, 16s; 54) is less than that of the green ceramic layers (13) in contact with the boundary-defining thick-film pattern (16, 16a, 16b; 16t, 16s; 54).

3. The method for producing a multilayer ceramic substrate according to claim 1, wherein the firing shrinkage rate of the at least one green boundary-defining thick-film pattern (16, 16a, 16b; 16t, 16s; 54) is greater than that of the ceramic layers (13) in contact with the at least one boundary-defining thick-film pattern (16, 16a, 16b; 16t, 16s; 54).

4. The method for producing a multilayer ceramic substrate according to claim 1, wherein the at least one boundary-defining thick-film pattern (16, 16a, 16b; 16t, 16s; 54) comprises a plurality of boundary-defining thick-film patterns, the plurality of boundary-defining thick-film patterns are arranged at different interfaces between the green ceramic layers (13), and at least a portion of an outer edge of each of the plurality of boundary-defining thick-film patterns is arranged in a common imaginary plane extending in the stacking direction of the green ceramic layers (13).

5. The method for producing a multilayer ceramic substrate according to claim 1, wherein
the first step includes a substep of arranging a green shrinkage inhibiting layer (20, 22) that is not substantially sintered at a firing temperature of the green ceramic layers (13) in close contact with at least one main surface of the green ceramic laminate (12a);
in the second step, the green ceramic laminate (12a) in close contact with the shrinkage inhibiting layer (20, 22) is fired at a temperature in the range of a sintering temperature of the ceramic layers (13) to a temperature at which the shrinkage inhibiting layer (20, 22) is not substantially sintered; and
the method further comprises a step of removing the shrinkage inhibiting layer (20, 22) in close contact with the sintered ceramic laminate (12b) between the second step and the third step.

6. The method for producing a multilayer ceramic substrate according to claim 1, wherein the at least one green boundary-defining thick-film pattern (16, 16a, 16b; 16t, 16s; 54) is a green boundary-defining conductive pattern including a conductive material.

7. The method for producing a multilayer ceramic substrate according to claim 6, wherein
the sintered ceramic laminate (12b) includes an internal circuit conductive pattern (14, 15) defining an embedded element arranged between the ceramic layers (13); and
the internal circuit conductive pattern (14, 15) is electrically separated from the boundary-defining conductive pattern (16, 16a, 16b; 16t, 16s; 54).

8. The method for producing a multilayer ceramic substrate according to claim 6, wherein at least a portion of the boundary-defining conductive pattern (16, 16a, 16b; 16t, 16s; 54) defines an embedded element arranged between the ceramic layers (13) of the sintered ceramic laminate (12b).

9. The method for producing a multilayer ceramic substrate according to claim 1, further comprising a step of mounting a surface-mounted electronic component on the sintered ceramic laminate (12b) before or after the sintered ceramic laminate (12b) is divided into the plurality of pieces (10a-10c).

## Patentansprüche

1. Ein Verfahren zum Herstellen eines Mehrschichtkeramiksubstrats, das folgende Schritte umfasst:
einen ersten Schritt des Bildens eines Grünkeramiklaminats (12a), das eine Mehrzahl von gestapelten Grünkeramikschichten (13) umfasst;
einen zweiten Schritt des Brennens des Grünkeramiklaminats (12a), um die Grünkeramikschichten (13) zu sintern; und
einen dritten Schritt des Teilens des gesinterten Keramiklaminats (12b), das durch Brennen des Grünkeramiklaminats (12a) gebildet wird, in eine Mehrzahl von Stücken (10a-10c);
wobei das Grünkeramiklaminat (12a), das bei dem ersten Schritt gebildet wird, zumindest eine grüne grenzdefinierende Dickfilmstruktur (16, 16a, 16b; 16t, 16s; 54) umfasst, die auf einer Hauptoberfläche von zumindest einer der Grünkeramikschichten (13) und entlang einem Abschnitt angeordnet ist, der der Grenze zwischen den Stücken (10a-10c) des gesinterten Keramiklaminats (12b) entspricht, das bei dem dritten Schritt geteilt wurde;
wobei die zumindest eine grüne grenzdefinierende Dickfilmstruktur (16, 16a, 16b; 16t, 16s; 54) Brennschwindungscharakteristika aufweist, die sich von denjenigen der Grünkeramikschichten (13) benachbart zu der zumindest einen grünen grenzdefinierenden Dickfilmstruktur (16, 16a, 16b; 16t, 16s; 54) unterscheiden;
wobei bei dem zweiten Schritt ein Hohlraum (18a, 18b, 56) gebildet wird aufgrund der Differenzen bei den Brennschwindungscharakteristika zwischen der zumindest einen grenzdefinierenden Dickfilmstruktur (16, 16a, 16b; 16t, 16s; 54) und den Keramikschichten (13) in Kontakt mit der zumindest einen grenzdefinierenden Dickfilmstruktur (16, 16a, 16b; 16t, 16s; 54);
wobei der Hohlraum (18a, 18b, 56) benachbart ist zu zumindest einem Teil eines äußeren Rands der zumindest einen grenzdefinierenden Dickfilmstruktur (16, 16a, 16b; 16t, 16s; 54) von der Stapelrichtung der Keramikschichten (13) aus gesehen; und
wobei bei dem dritten Schritt das gesinterte Keramiklaminat (10a-10c) entlang dem Hohlraum (18a, 18b, 56) in die Mehrzahl von Stücken (10a-10c) geteilt wird.

2. Das Verfahren zum Herstellen eines Mehrschichtkeramiksubstrats gemäß Anspruch 1, bei dem die Brennschwindungsanfangstemperatur der zumindest einen grünen grenzdefinierenden Dickfilmstruktur (16, 16a, 16b; 16t, 16s; 54) geringer ist als diejenige der Grünkeramikschichten (13) in Kontakt mit der grenzdefinierenden Dickfilmstruktur (16, 16a, 16b; 16t, 16s; 54).

3. Das Verfahren zum Herstellen eines Mehrschichtkeramiksubstrats gemäß Anspruch 1, bei dem die Brennschwindungsrate der zumindest einen grünen grenzdefinierenden Dickfilmstruktur (16, 16a, 16b; 16t, 16s; 54) größer ist als diejenige der Keramikschichten (13) in Kontakt mit der zumindest einen grenzdefinierenden Dickfilmstruktur (16, 16a, 16b; 16t, 16s; 54).

4. Das Verfahren zum Herstellen eines Mehrschichtkeramiksubstrats gemäß Anspruch 1, bei dem die zumindest eine grenzdefinierende Dickfilmstruktur (16, 16a, 16b; 16t, 16s; 54) eine Mehrzahl von grenzdefinierenden Dickfilmstrukturen umfasst, wobei die Mehrzahl von grenzdefinierenden Dickfilmstrukturen an unterschiedlichen Grenzflächen zwischen den Grünkeramikschichten (13) angeordnet ist, und zumindest ein Teil eines äußeren Rands von jeder der Mehrzahl von grenzdefinierenden Dickfilmstrukturen in einer gemeinsamen imaginären Ebene angeordnet ist, die sich in der Stapelrichtung der Grünkeramikschichten (13) erstreckt.

5. Das Verfahren zum Herstellen eines Mehrschichtkeramiksubstrats gemäß Anspruch 1, bei dem
der erste Schritt einen Teilschritt des Anordnens einer grünen Schwindungshemmschicht (20, 22) umfasst, die bei einer Brenntemperatur der Grünkeramikschichten (13) in engem Kontakt mit zumindest einer Hauptoberfläche des Grünkeramiklaminats (12a) nicht wesentlich gesintert wird;
bei dem zweiten Schritt das Grünkeramiklaminat (12a) in engem Kontakt mit der Schwindungshemmschicht (20, 22) gebrannt wird bei einer Temperatur in dem Bereich einer Sintertemperatur der Keramikschichten (13) zu einer Temperatur, bei der die Schwindungshemmschicht (20, 22) nicht wesentlich gesintert wird; und
das Verfahren ferner einen Schritt des Entfernens der Schwindungshemmschicht (20, 22) in engem Kontakt mit dem gesinterten Keramiklaminat (12b) umfasst, zwischen dem zweiten Schritt und dem dritten Schritt.

6. Das Verfahren zum Herstellen eines Mehrschichtkeramiksubstrats gemäß Anspruch 1, bei dem die zumindest eine grüne grenzdefinierende Dickfilmstruktur (16, 16a, 16b; 16t, 16s; 54) eine grüne grenzdefinierende leitfähige Struktur ist, die ein leitfähiges Material umfasst.

7. Das Verfahren zum Herstellen eines Mehrschichtkeramiksubstrats gemäß Anspruch 6, bei dem
das gesinterte Keramiklaminat (12b) eine leitfähige Struktur (14, 15) einer inneren Schaltung umfasst, die ein eingebettetes Element definiert, das zwischen den Keramikschichten (13) angeordnet ist; und
die leitfähige Struktur (14, 15) einer inneren Schaltung elektrisch getrennt ist von der grenzdefinierenden leitfähigen Struktur (16, 16a, 16b; 16t, 16s; 54).

8. Das Verfahren zum Herstellen eines Mehrschichtkeramiksubstrats gemäß Anspruch 6, bei dem zumindest ein Teil der grenzdefinierenden leitfähigen Struktur (16, 16a, 16b; 16t, 16s; 54) ein eingebettetes Element definiert, das zwischen den Keramikschichten (13) des gesinterten Keramiklaminats (12b) angeordnet ist.

9. Das Verfahren zum Herstellen eines Mehrschichtkeramiksubstrats gemäß Anspruch 1, das ferner einen Schritt des Befestigens einer oberflächenbefestigten Elektronikkomponente auf dem gesinterten Keramiklaminat (12b) umfasst, bevor oder nachdem das gesinterte Keramiklaminat (12b) in die Mehrzahl von Stücken (10a-10c) geteilt wird.

## Revendications

1. Procédé de production d'un substrat céramique multicouche, comprenant :
une première étape consistant à former un stratifié céramique cru (12a) comprenant une pluralité de couches céramiques crues empilées (13) ;
une deuxième étape consistant à cuire le stratifié céramique cru (12a) pour fritter les couches céramiques crues (13) ; et
une troisième étape consistant à subdiviser le stratifié céramique fritté (12b), formé par cuisson du stratifié céramique cru (12a), en une pluralité de pièces (10a - 10c) ;
le stratifié céramique cru (12a) formé dans la première étape comprenant au moins un motif en couche épaisse crue définissant une frontière (16, 16a, 16b ; 16t, 16s ; 54), disposé sur une surface principale d'au moins l'une des couches céramiques crues (13) et le long d'une partie correspondant à la frontière entre les pièces (10a - 10c) du stratifié céramique fritté (12b) subdivisé dans la troisième étape ;
l'au moins un motif en couche épaisse crue définissant une frontière (16, 16a, 16b ; 16t, 16s ; 54) ayant des caractéristiques de retrait à la cuisson qui sont différentes de celles des couches céramiques crues (13) contiguës à l'au moins un motif en couche épaisse crue définissant une frontière (16, 16a, 16b ; 16t, 16s ; 54) ;
dans la deuxième étape, une cavité (18a, 18b ; 56) étant formée en raison des différences entre les caractéristiques de retrait à la cuisson de l'au moins un motif en couche épaisse définissant une frontière (16, 16a, 16b ; 16t, 16s ; 54) et celles des couches céramiques (13) en contact avec l'au moins un motif en couche épaisse définissant une frontière (16, 16a, 16b ; 16t, 16s ; 54) ;
la cavité (18a, 18b ; 56) étant contiguë à au moins une partie d'un bord externe de l'au moins un motif en couche épaisse définissant une frontière (16, 16a, 16b ; 16t, 16s ; 54), lorsqu'on regarde dans la direction d'empilement des couches céramiques (13) ; et
dans la troisième étape, le stratifié céramique fritté (10a - 10c) étant subdivisé en la pluralité de pièces (10a - 10c) le long de la cavité (18a, 18b ; 56).

2. Procédé de production d'un substrat céramique multicouche selon la revendication 1, dans lequel la température d'amorçage de retrait à la cuisson de l'au moins un motif en couche épaisse crue définissant une frontière (16, 16a, 16b ; 16t, 16s ; 54) est inférieure à celle des couches céramiques crues (13) en contact avec le motif en couche épaisse définissant une frontière (16, 16a, 16b ; 16t, 16s ; 54).

3. Procédé de production d'un substrat céramique multicouche selon la revendication 1, dans lequel le taux de retrait à la cuisson de l'au moins un motif en couche épaisse crue définissant une frontière (16, 16a, 16b ; 16t, 16s ; 54) est supérieur à celui des couches céramiques (13) en contact avec l'au moins un motif en couche épaisse définissant une frontière (16, 16a, 16b ; 16t, 16s ; 54).

4. Procédé de production d'un substrat céramique multicouche selon la revendication 1, dans lequel l'au moins un motif en couche épaisse définissant une frontière (16, 16a, 16b ; 16t, 16s ; 54) comprend une pluralité de motifs en couche épaisse définissant des frontières, la pluralité de motifs en couche épaisse définissant des frontières étant disposée à différentes interfaces entre les couches céramiques crues (13), et au moins une partie d'un bord externe de chaque motif de la pluralité de motifs en couche épaisse définissant des frontières étant disposée dans un plan fictif commun s'étendant dans la direction d'empilement des couches céramiques crues (13).

5. Procédé de production d'un substrat céramique multicouche selon la revendication 1, dans lequel :
la première étape comprend une sous-étape consistant à disposer une couche crue inhibitrice de retrait (20, 22), qui n'est pas entièrement frittée à une température de cuisson des couches céramiques crues (13) en contact étroit avec au moins une surface principale du stratifié céramique cru (12a) ;
dans la deuxième étape, le stratifié céramique cru (12a) en contact étroit avec la couche inhibitrice de retrait (20, 22) est cuit à une température comprise dans l'intervalle allant d'une température de frittage des couches céramiques (13) à une température à laquelle la couche inhibitrice de retrait (20, 22) n'est pas entièrement frittée ; et
le procédé comprenant en outre une étape consistant à enlever la couche inhibitrice de retrait (20, 22) en contact étroit avec le stratifié céramique fritté (12b) entre la deuxième et la troisième étapes.

6. Procédé de production d'un substrat céramique multicouche selon la revendication 1, dans lequel l'au moins un motif en couche épaisse crue définissant une frontière (16, 16a, 16b ; 16t, 16s ; 54) est un motif conducteur cru définissant une frontière, contenant un matériau conducteur.

7. Procédé de production d'un substrat céramique multicouche selon la revendication 6, dans lequel
le stratifié céramique fritté (12b) comprend un motif conducteur formant circuit interne (14, 15) définissant un élément enrobé disposé entre les couches céramiques (13) ; et
le motif conducteur formant circuit interne (14, 15) est électriquement séparé du motif conducteur définissant une frontière (16, 16a, 16b ; 16t, 16s ; 54).

8. Procédé de production d'un substrat céramique multicouche selon la revendication 6, dans lequel au moins une partie du motif conducteur définissant une frontière (16, 16a, 16b ; 16t, 16s ; 54) définit un élément enrobé disposé entre les couches céramiques (13) du stratifié céramique fritté (12b).

9. Procédé de production d'un substrat céramique multicouche selon la revendication 1, comprenant en outre une étape consistant montage un composant électronique en surface sur le stratifié céramique fritté (12b) avant ou après la subdivision du stratifié céramique fritté (12b) en la pluralité de pièces (10a - 10c).
